Europäisches Patentamt

European Patent Office

Office européen des brevets

(19)

(11) EP 0 819 988 A1

(12) **EUROPEAN PATENT APPLICATION**

(43) Date of publication:
**21.01.1998 Bulletin 1998/04**

(51) Int Cl.6: **G03F 7/20**

(21) Application number: **97202676.9**

(22) Date of filing: **30.10.1991**

(84) Designated Contracting States:
**DE FR GB IT NL**

(30) Priority: **30.10.1990 JP 293162/90**
**11.09.1991 JP 231530/91**

(62) Document number(s) of the earlier application(s) in
accordance with Art. 76 EPC:
**91310024.4 / 0 484 131**

(71) Applicant: **NIKON CORPORATION**
**Tokyo (JP)**

(72) Inventors:
• **Sakakibara, Yasuyuki**
**Tokyo (JP)**

• **Makinouchi, Susumu**
**Zama-shi, Kanagawa-ken (JP)**
• **Magome, Nobutaka**
**Kawasaki-shi, Kanagawa-ken (JP)**
• **Shiraishi, Naomasa**
**Kawasaki-shi, Kanagawa-ken (JP)**

(74) Representative: **Burke, Steven David et al**
**R.G.C. Jenkins & Co.**
**26 Caxton Street**
**London SW1H 0RJ (GB)**

Remarks:
This application was filed on 01 - 09 - 1997 as a
divisional application to the application mentioned
under INID code 62.

(54) **Projection exposure apparatus**

(57) In a projection exposure apparatus wherein a
stage (14) is moved in the direction of optic axis when
a mask (R) formed with a predetermined pattern is pro-
jected by a shutter (3) onto a photosensitive substrate
(W) placed on the stage through a projection optical sys-
tem (PL), the operations of control means (22) for the
shutter and control means (18) for the stage are inter-
locked with each other on the basis of the operational
characteristic of the shutter and the operational characteristics (particularly the speed characteristic) of the
stage so that the distribution of the existence probability
with respect to movement of the photosensitive sub-
strate from the opening operation starting point of time
till the closing operation completing point of time of the
shutter, with respect to the direction of the optic axis,
may assume substantially equal maximum values at at
least two locations in the direction of the optic axis.

FIG.4

## Description

## BACKGROUND OF THE INVENTION

### Field of the Invention

This invention relates to an apparatus for projecting and exposing a semiconductor circuit pattern, a liquid crystal display element pattern or the like onto a photosensitive substrate.

### Related Background Art

In a projection exposure apparatus of this kind, the exposure of a reticle pattern has heretofore been effected with the surface of a photosensitive substrate (a semiconductor wafer or a glass plate having a resist layer applied thereto) disposed on the best imaging plane of a projection optical system (a plane conjugate with the reticle).

However, the area exposed once on the wafer (the shot area) is of the order of 15 mm square to 20 mm square, and if the surface of the wafer is minutely curved in that area or there is unevenness of the order of several µm in the surface structure, there will appear in the shot area a portion which exceeds the depth of focus of the projection optical system. This is because the depth of focus of the projection optical system is only ±1 µm or so on the image side (the wafer side).

So, a method whereby exposure can be effected at an effectively wide depth of focus even in an exposure apparatus having a projection optical system of a small depth of focus has been proposed in U.S. Patent No. 4,869,999. In the method disclosed in this patent, a wafer is moved to two or three points in the direction of the optic axis of the projection optical system and one and the same reticle pattern is multiplexly exposed at each point. In this method, two points distant in the direction of the optic axis are made nearly as wide as the depth of focus $\pm\Delta Z$ of the projection optical system, thereby enlarging the actually effective depth to the order of 1.5 - 3 times.

In addition to the method as described in the above-mentioned patent wherein the wafter is positioned at each of multiple points in the direction of the optic axis and exposure is repeated, there has been proposed a method whereby the wafer is continuously moved (or vibrated) in the direction of the optic axis during an exposure operation for one shot area.

A semiconductive integrated circuit is manufactured by the steps of film formation, pattern transfer, etching, etc. being repeated several to ten and several times. Therefore, in some cases, portions in which film corresponding to several layers is laminated and portions in which no film is laminated are mixedly present on the surface of a wafer which is in the process of forming an integrated circuit. The thickness of a layer in the film is of the order of 0.1 µm to 1 µm, and the level difference on the wafer surface (in one shot area) may be of the order of several µm at greatest. On the other hand, the depth of focus of the projection optical system is generally expressed as $\pm\lambda/2\cdot NA^2$, where $\lambda$ is the wavelength of illuminating light for exposure, and NA is the numeral aperture of the image plane side of the projection optical system. In the latest projection optical systems, $\lambda = 0.365$ µm (the i-line of a mercury lamp) and NA $\simeq 0.5$, and the depth of focus $\Delta Z$ in this case is about ±0.73 µm.

Accordingly, when as in the prior art, exposure is effected with a wafer fixedly disposed on the best imaging plane of the projection optical system, both the top and bottom of the level difference on the wafer become distant in the direction of the optic axis by more than the depth of focus of ±0.73 µm relative to the best imaging plane (the best focus plane) and thus, image formation becomes impossible.

Also, according to a method whereby as in the prior art, exposure is effected plural times with a wafer positioned at multiple points separate in the direction of the optic axis, it is possible to cope with a level difference of several µm on the wafer, but a shutter system must be driven to stop and resume exposure at multiple points in the direction of the optic axis, and this has led to the problem that the wafer treating ability per unit time is greatly reduced under the influences of the driving of a drive stage (Z stage) in the direction of the optic axis (Z direction) of a wafer holder, the positioning operation characteristic and the opening and closing of the shutter.

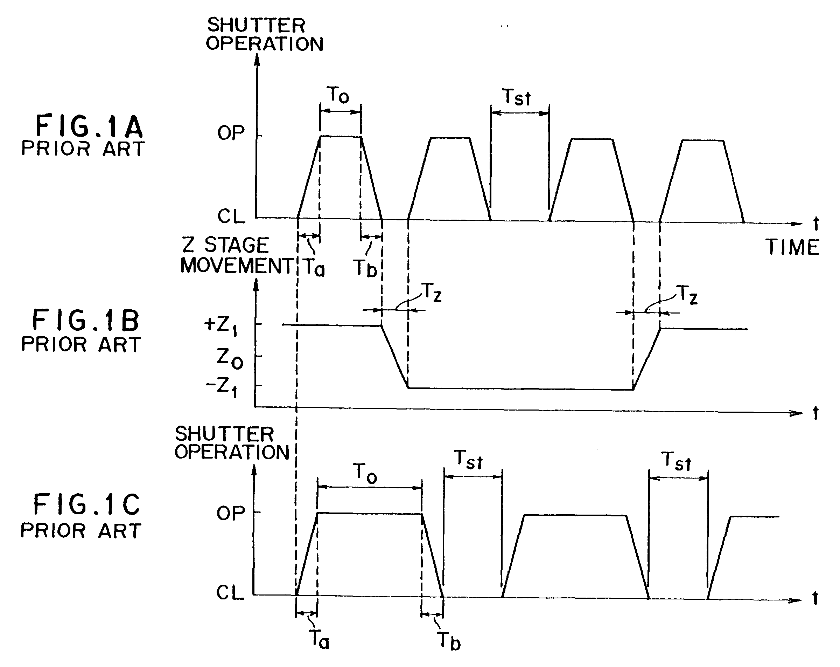

So, an example of the prior-art exposure method will hereinafter be described with reference to Figures 1A - 1C of the accompanying drawings. Figures 1A and 1B show the time charts of the shutter operation (the variation in the illumination on a wafer) and the Z stage operation when multiplex exposure is effected at two focus positions to one shot area, and Figure 1C shows the time chart of the shutter operation in a normal mode in which multiplex exposure is not effected.

Here, it is to be understood that during multiplex exposure and during normal exposure, the same exposure amount is provided to one shot area on a wafer. In the case of normal exposure, assuming that the operation time Ta until the closed shutter is opened and the operation time Tb until the shutter is closed from its fully open state are of a substantially equal value (Tc), a proper exposure amount BV is BV = (Tc + $T_O$') x IL, where $T_O$' is the fully open time of the shutter, and IL represents the illumination of the surface of the wafer. Also, in Figures 1A and 1C, the ordinate OP. represents the fully open state of the shutter and CL. represents the fully closed state of the shutter. Further, in Figure 1, time Tst represents the stepping time to the next shot area of the wafer stage.

On the other hand, in the case of multiplex exposure, the first exposure is effected with the Z stage set at a position $+Z_1$ upwardly distant from the best focus plane $Z_0$ as shown in Figure 1B, whereafter the Z stage is re-set at a position $-Z_1$ downwardly distant from the plane $Z_0$ during a time $T_Z$, and then the second exposure is effected.

The operational characteristics (rising and falling) of the shutter do not vary as long as one and the same exposure apparatus is used and therefore, the first exposure time is $Ta + Tb + T_O$, where $T_O$ is the fully open time of the shutter, and if the first exposure amount is about one half of the proper exposure amount BV, the fully open time $T_O$ is defined as follows (but $BV/IL = Tc + T_O'$):

$$T_O = \frac{BV}{2 \cdot IL} - Tc = \frac{1}{2}(T_O' - Tc)$$

Thus, as is apparent from Figures assuming that $Ta = Tb = Tc$, in the case of normal sensitization, the overall treatment time which gives the proper exposure amount BV to each shot area on the wafer is

$$(2Tc + T_O' + Tst) \times \text{ the number of shots} \tag{1}$$

and in the case of multiplex (two times) exposure, said over all treatment time is

$$\{2(2Tc + T_O + T_Z + Tst\} \times \text{ the number of shots.} \tag{2}$$

Substituting $T_O = 1/2(T_O' - Tc)$ for this expression (2) and rearranging it,

$$(3Tc + T_O' + T_Z + Tst) \times \text{ the number of shots.} \tag{3}$$

So, comparing expressions (1) and (3) with each other, it will be seen that in the case of multiplex exposure, the time becomes longer by $(Tc + T_O)$ during each shot.

In the present-day exposure apparatuses (steppers), the time Tc is 10 - 30 mSec. and the time $T_Z$, although it differs depending on the strokes of positions $+Z_1$ and $-Z_1$, is of the order of 20 - 50 mSec. Therefore, the time becomes longer by the order of 30 - 80 mSec. during each shot, and assuming that there are 100 shot areas on a wafer, the treatment of one wafer may become longer by 3 to 8 sec.

As described above, the prior-art method has suffered from a problem is the throughput of wafer treatment.

### SUMMARY OF THE INVENTION

The present invention has been made in view of the above-noted problem and the object thereof is to provide a projection exposure apparatus in which the substantial depth of focus is enlarged and at the same time, the reduction in throughput is decreased and in addition, the controllability of exposure amount is secured.

To achieve this object, the present invention is constructed as follows.

A Z stage is moved in the direction of the optic axis during exposure of a photosensitive substrate.

Interlocking means for interlocking the operations of control means for a shutter and control means for the Z stage is provided so that on the basis of the operational characteristics of the shutter and the operational characteristics (particularly the speed characteristic) of a movable stage (Z stage), the distribution of the existence probability (i.e., the existence time per unit length in the Z direction) obtained under the movement of said substrate photosensitive substrate (a resist layer on a wafer from a point of time at which the shutter starts to be closed till a point of time at which the shutter is completely closed, with respect to the direction of the optic axis may assume substantially equal maximum values at least two locations in the direction of the optic axis.

In the present invention, there is adopted a system for moving the photosensitive substrate such as the wafer and the projected image relative to each other in the direction of the optic axis while the shutter is open, so as to endow the opening-closing control characteristic of the shutter and the movement control characteristic in the direction of the optic axis with a special relation.

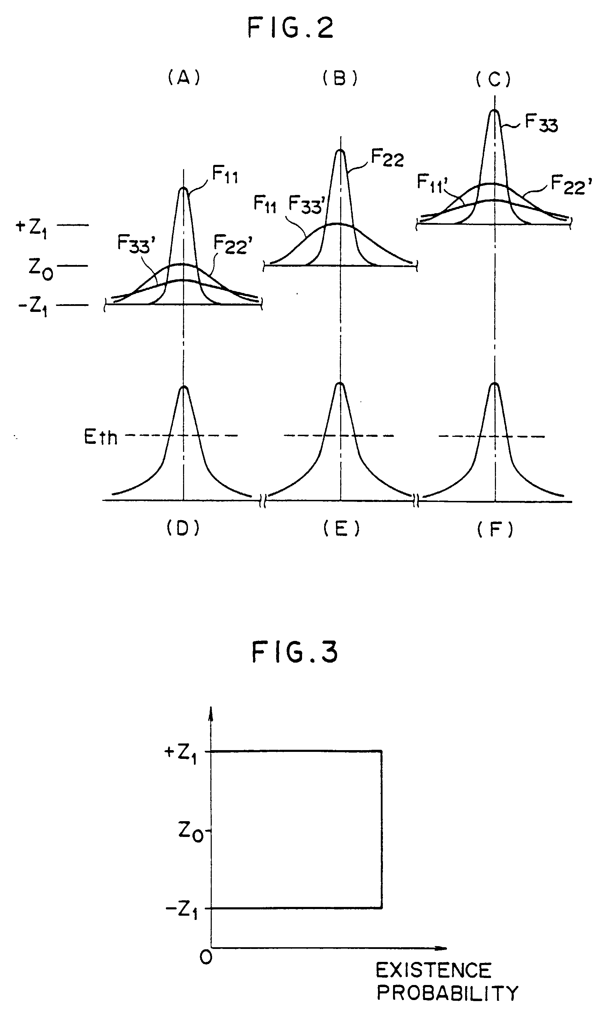

The manner of exposure by the prior-art multiplex exposure system will now be described with reference to Figure 2 of the accompanying drawings.

Figure 2, (A), (B) and (C) show the manners of multiplex exposure at focus positions $-Z_1$, $Z_0$ and $+Z_1$, respectively, and the low portion, the middle portion and the high portion of the pattern level difference on a wafer are represented as (A), (B) and (C), respectively. The pattern to be subjected to multiplex exposure exists as a hole pattern (a white minute rectangle) formed on a reticle. The intensity distribution of the projected image of this hole pattern on the wafer is shown by Fmn, and m=1 represents the focus position $-Z_1$, m=2 represents the focus position $Z_0$, m=3 represents the focus position $+Z_1$, and n=1, 2, 3 represents the number of times (order) of exposure.

When at first, the first exposure is effected with the best imaging plane of a projection lens focused on the low portion (the position $-Z_1$) of the pattern level difference on the wafer, a sharp intensity distribution $F_{11}$ is imaged on the low portion, but toward the middle and high portions, the intensity distribution $F_{11}$, is suddenly deteriorated (decreased in peak value and increased in width). When the second exposure is then effected with the best imaging plane focused on the middle portion (the position $Z_0$) of the pattern level difference, a sharp intensity distribution $F_{22}$ is imaged on the middle portion, but a deteriorated intensity distribution $F_{22}'$ appears on each of the low portion and the high portion. Likewise in the third exposure, focusing is effected on the high portion ($+Z_1$) of the pattern level difference and therefore, a sharp intensity distribution $F_{33}$ is obtained in the high portion, and toward the middle portion and the low portion, a deteriorated intensity distribution $F_{33}'$ is obtained.

When three times of exposure is thus finished, sharp image distributions $F_{11}$, $F_{22}$ and $F_{33}$ are obtained once in any of the low portion, the middle portion and the hight portion of the pattern level difference.

The integrated quantity of light of the intensity distributions $F_{11}$, $F_{22}'$ and $F_{33}'$ is provided to the resist of the low portion, as shown in Figure 2(A), and the distribution of the integrated quantity of light is as shown in Figure 2(D). In Figure 2(D), the level Eth indicated by a broken line is the exposure amount necessary to remove positive resist (form a hole pattern). Likewise the integrated quantity of light of the intensity distributions $F_{22}$, $F_{11}'$ and $F_{33}'$ is provided to the resist of the middle portion of the pattern level difference, as shown in Figure 2(E), and the integrated quantity of light of the intensity distributions $F_{33}$, $F_{11}'$ and $F_{22}'$ is provided to the resist of the high portion of the pattern level difference, as shown in Figure 2(F). A good image intensity distribution of a hole pattern is provided to any of these three level difference portions and as a result, the apparent enlargement of the depth of focus is accomplished over the width of $2Z_1$ from the high portion to the low portion of the level difference.

Besides the above-described method of effecting multiplex exposure while discretely varying the focus position, the effect of enlarging the depth of focus is also obtained by a method of effecting exposure while continuously moving a wafer in the direction of the optic axis. However, according to the comfirmation through experiments or the like, it has been found that the expected enlarging effect cannot be attained even if a wafer is moved (or vibrated) atrandom in the direction of the optic axis during the exposure of the wafer (during the opening of the shutter).

Assuming that as a generally conceivable moving system, a Z stage holding a wafer thereon is driven at a uniform speed, the time distribution of the best focus image with respect to the direction of the optic axis, i.e., the so-called existence probability, is shown in Figure 3 of the accompanying drawings. In Figure 3, the ordinate represents the focus position (the position of the wafer in the direction of the optic axis) and the abscissa represents the existence probability (i.e., the time per unit length in the direction of the optic axis with which the best focus image exists). In the previously described three-point multiplex exposure, the existence probability has assumed other values than zero only at the three focus positions $+Z_1$, $Z_0$ and $-Z_1$, but in the uniform speed movement of the Z stage, a constant existence probability is assumed over the entire range of $\pm Z_l$, and besides the enlarging effect for the depth of focus, the disadvantage of the aggravated contrast of the exposed resist pattern presents itself remarkably.

Also, in the technique of vibrating the wafer in the direction of the optic axis during the exposure of the wafer, the enlarging effect for the depth of focus may not be sufficiently expected depending on the amplitude, frequency and waveform of the vibration and the exposure time.

So, in the present embodiment, the continuous movements of the wafer and the projection image plane in the direction of the optic axis are controlled so that the existence probability may be maximized at the focus positions $+Z_1$ and $-Z_1$, in other words, two points distant from each other by an amount roughly corresponding to the width of the depth of focus of the projection lens and that in the intermediate portion between the two points, the existence probability may be suppressed low to such an extent that will not cause the deterioration of the contrast of the exposed resist pattern.

## BRIEF DESCRIPTION OF THE DRAWINGS

Figures 1A - 1C are times charts showing the driving sequences of the Z stage and shutter in the multiplex exposure system according to the prior art.

Figures 2, (A) to (F) illustrate the variation in the distribution of quantity of light of a hole pattern when multiplex exposure is effected at three points.

Figure 3 shows the distribution of exposure amount (existence probability) when exposure is effected while the Z stage is moved at a uniform speed.

Figure 4 shows the construction of a projection exposure apparatus according to an embodiment of the present invention.

Figure 5 is a block diagram showing the construction of the main control system in Figure 4.

Figures 6A - 6C are graphs showing an example of the illumination variation characteristic resulting from the opening-closing of a shutter and the driving characteristic of the Z stage.

Figure 7 is a graph showing the distribution of existence probability in Z direction (the direction of the optic axis) obtained under the movement conditions of Figure 6.

Figure 8 is a graph showing the distribution when the exposure amount is concentrated in three locations in Z direction.

Figure 9 is a graph showing the simulated distribution of existence probability.

Figure 10 is a diagram showing the condition to simulate the distribution of light amount of a contact hole image.

DESCRIPTION OF THE PREFERRED EMBODIMENTS

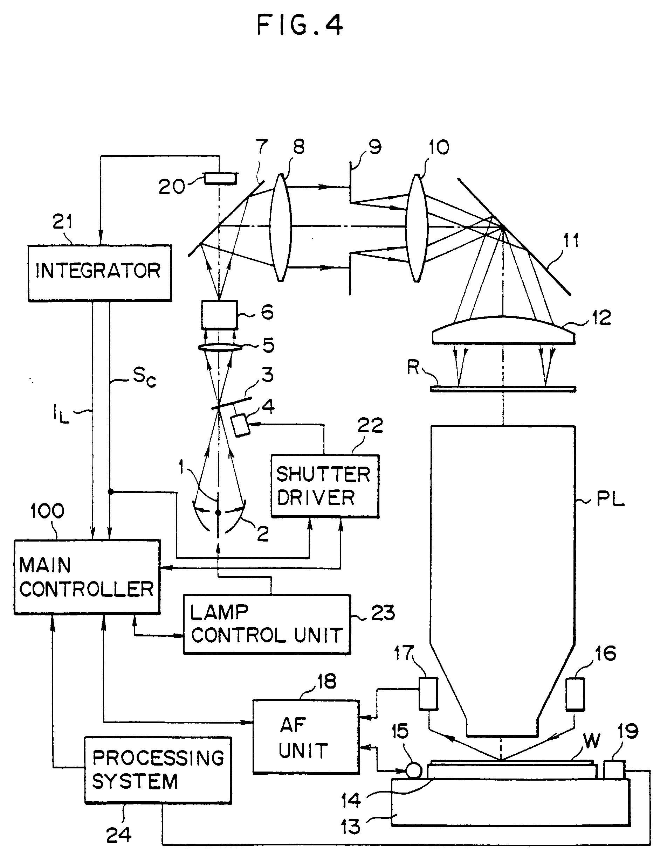

Figure 4 shows the construction of a projection exposure apparatus according to an embodiment of the present invention.

In Figure 4, illuminating light from a mercury discharge lamp 1 is condensed on a second focus by an elliptical mirror 2. A rotary shutter 3 having a plurality of blades is disposed near the second focus for rotation by a motor 4. The illuminating light condensed on the second focus and transmitted through the shutter 3 enters an optical integrator 6 including an input lens 5, a fly-eye lens, etc. A plurality of secondary light source images are formed on the exit surface side of the optical integrator 6, whereby a surface light source is made. The illuminating lights from the respective secondary light source images are reflected by a mirror 7 having a slight transmittance (e.g. of the order of 10%), whereafter they enter a first relay lens system 8 and are integrated by the surface of a reticle blind 9, and illuminate the blind 9 with a uniformized illumination distribution. The blind 9 is for limiting the illuminated range on a reticle R, and the opening image of the blind 9 is formed on the pattern surface of the reticle R through a second relay lens system 10, a mirror 11 and a condenser lens 12.

The illuminating light transmitted through the transparent portion of the pattern of the reticle R passes through a projection lens PL to a wafer W, and the projected image of the reticle pattern is formed near the surface of the wafer W. The wafer W is vacuum-attracted onto the holder of a Z stage 14 disposed on an XY stage 13. The Z stage 14 is moved on the XY stage 13 in the direction of the optic axis of the projection lens PL by a driving portion (a motor and a tachogenerator) 15.

Usually, the Z stage 14 is moved in the direction of the optic axis by the driving portion 15 being servo-operated under the control of an AF unit 18 which inputs a focus signal from an oblique incident light type AF sensor comprised of a light projector 16 and a light receiving device 17. This is an auto-focus operation effected during normal one-time exposure.

A photoelectric sensor 19 for detecting the intensity of the illuminating light (the pattern image of the reticle R or the opening image of the blind 9) passed through the projection lens PL is provided on the XY stage 13.

Now, a photoelectric sensor 20 for detecting the intensity of part of the illuminating light passed through the shutter 3 is disposed rearwardly of the mirror 7, and the photoelectric signal of the photoelectric sensor 20 is input to an integrator circuit 21 which digitally effects the integration of the quantity of light. The integrator circuit 21 outputs to a main control system 100 a signal IL obtained by the photoelectric signal being amplified by a predetermined amount. The signal IL is proportional to the illumination on the reticle R or the illumination on the wafer W. Further, the integrator circuit 21 includes a comparison circuit which outputs the closing signal Sc of the shutter 3 from the main control system 100 when the value of a preset proper exposure amount and the integrated value of the quantity of light coincide with each other. This closing signal Sc is sent to a shutter driver 22, whereby the motor 4 is rotated by a predetermined amount to thereby close the shutter 3. Also, the driver 22 exchanges an opening command for the shutter 3, a shutter status signal, etc. between it and the main control system 100.

In the case of normal one-time exposure, automatic exposure amount control is effected by the loop of the photoelectric sensor 20, integrator circuit 21, shutter driver 22 and motor 4. On the other hand, the mercury discharge lamp (hereinafter simply referred to as the lamp) 1 has its supplied electric power controlled by a lamp control unit 23. In recent years, in steppers, in order to enhance the throughput of exposure, there has been adopted a flash exposure system whereby the supplied electric power to the lamp 1 is increased to about twice the rated electric power only when the shutter 3 is open. The lamp control unit 23 is given a changeover command for the normal exposure system or the flash exposure system from the main control system 100, and in the case of flash exposure, it increases the supplied electric power to the lamp 1 in response to the start of the opening of the shutter 3.

The XY stage 13 in Figure 4 steps so as to move respective ones of the plurality of shot areas on the wafer W to just beneath the projection lens PL, but this is not directly related to the present invention and therefore, the driving portion and the control system for the XY stage 13 are not shown.

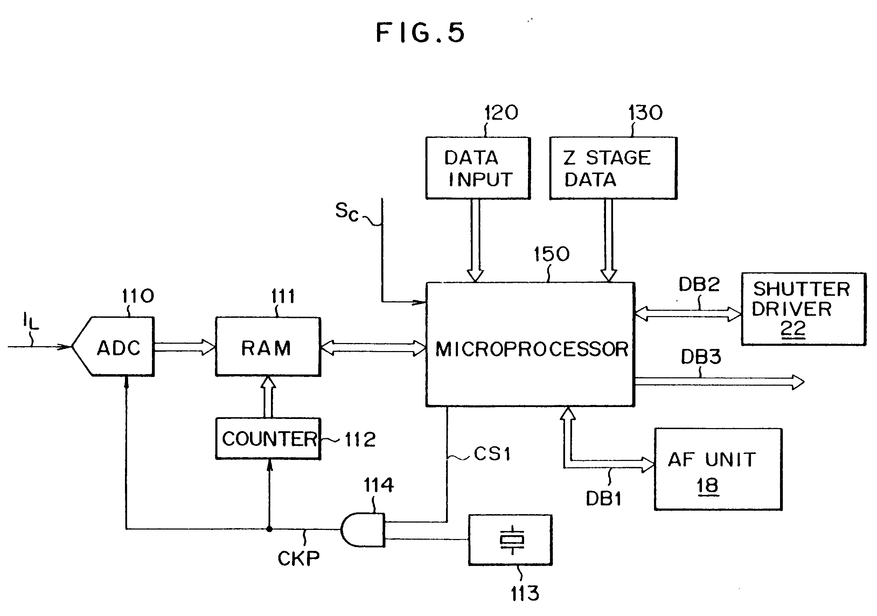

The functional blocks of the main control system 100 relating to the essential portions of the present invention will now be described with reference to Figure 5. The function of each block in Figure 5 is achieved by the hardware of an electric circuit or the software of a microcomputer or the like.

In Figure 5, an analog-digital converter ADC 110 receives as an input the amplified photoelectric signal IL from the photoelectric sensor 20, and converts the level of the signal IL into a digital value during each predetermined sampling time. The converted digital value is stored in a memory (RAM) 111 in order of address. The address value of the RAM 111 is generated by a counter 112, and this counter 112 counts the pulse number of a clock pulse CKP made by a clock generator 113 only while the clock pulse CKP passes through a gate 114. The opening and closing of the gate 114 are changed over by a signal CS, from a microprocessor ($\mu$P) 150.

This microprocessor uP 150 is connected to both of the AF unit 18 and the shutter driver 22 in Figure 4 through bus lines $DB_1$ and $DB_2$, and effects the exchange of data necessary for control. A data input portion (or a man machine interface) 120 receives as inputs commands and data from the operator, and main commands are a changeover command for multiplex exposure or normal exposure and an exposure starting command, and main data are the proper (target) exposure amount per shot and the movement width ($2Z_1$) of the Z stage 14 during multiplex exposure. A Z stage characteristic data portion 130 stores therein chiefly the data of the movement speed characteristic of the Z stage 14 (the maximum speed value, the acceleration value, etc.). The data of this speed characteristic can be easily found by converting the output value from the tachogenerator provided in the driving portion 15 for the Z stage 14 into a digital value by an A/D converter during each predetermined sampling time, and reading the digital value into the memory in the microprocessor $\mu$P 150 through the bus line $DB_1$, and thereafter analyzing it by the microprocessor $\mu$P 150. The data thus found by the microprocessor $\mu$P are stored in the Z stage characteristic data portion 130, but the Z stage may sometimes differ in its speed characteristic between a case where it is moved from below to above and a case where it is moved frcm above to below and therefore, it is preferable to find and store speed characteristics with respect to the both cases.

The microprocessor $\mu$P 150 controls the stoppage of the outputting of the signal $CS_1$ to the gate 114 on the basis of the inputting of the closing signal Sc of the shutter 3. Further, the microprocessor $\mu$P 150 outputs various warnings to the operator through a bus line $DB_3$. As one of the warnings, it is reported that it is difficult to effect multiplex exposure under exposure conditions input to the data input portion 120 and accordingly, it is necessary to revise some of the conditions.

The basic operation of the present embodiment will now be described.

Let it be assumed that the shutter 3 in Figure 4 is in its closed state, the lamp control unit 23 is set to the normal exposure system, and the integrated value of the quantity of light in the integrator circuit 21 is reset to zero.

Prior to exposure, the microprocessor $\mu$P 150 sets the value of the proper exposure amount input to the data input portion 120 in one input of the comparison circuit of the integrator circuit 21 and also outputs an opening command for the shutter 3 to the shutter driver 22 through the bus line $DB_2$ in the one-time exposure mode with the wafer W being absent under the projection lens PL. Thereby, the shutter driver 22 controls the closing of the shutter 3 so that the exposure amount on the reticle R or the wafer W may be a proper value. At this time, the microprocessor $\mu$P 150 delivers the signal $CS_1$ to the gate 114 simultaneously with the generation of the opening command for the shutter, and starts the counting up by the counter 112. The counting up by the counter 112 is stopped by the outputting of the signal $CS_1$ being discontinued in a predetermined time after the shutter closing signal Sc is produced. That predetermined time is made somewhat longer than the operational delay (electrical and mechanical delay) during the closing of the shutter.

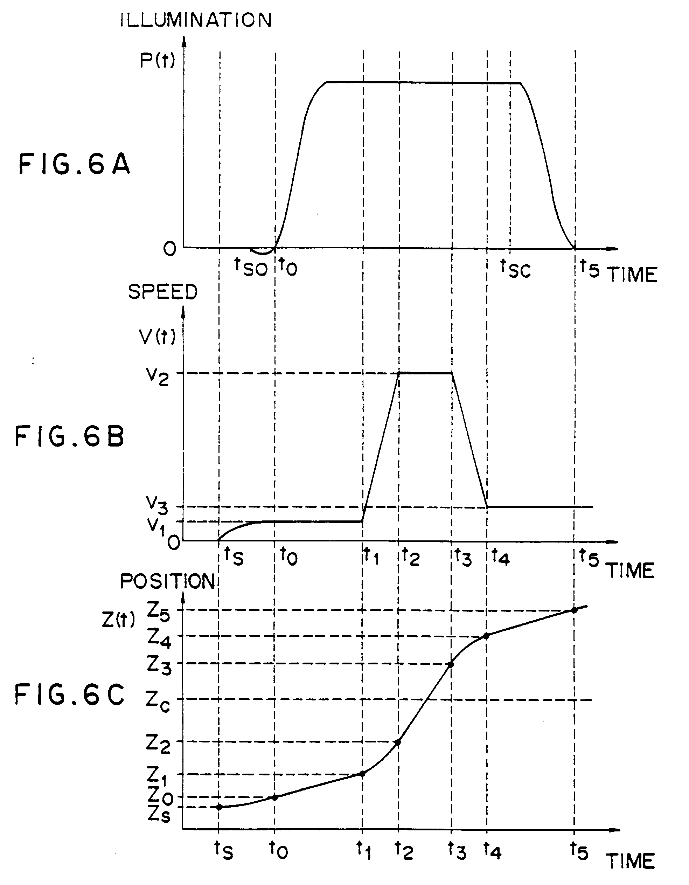

When in this manner, dummy exposure is effected in the one-time exposure mode under conditions under which proper exposure is obtained for a predetermined wafer, an illumination variation characteristic P(t) on the reticle is obtained in the RAM 111 in Figure 5 as shown, for example, in Figure 6A.

The ordinate of this characteristic P(t) represents the illumination value, and the absciss-a represents time and it is to be understood that, at a time $t_{SO}$, the signal $CS_1$ in Figure 5 is produced and the counting up by the counter 112 is started. Also, a time $t_{SC}$ in Figure 6A represents a point of time at which the shutter closing signal Sc is produced from the integrator circuit 21.

Further, a time $t_0$ on the characteristic P(t) represnets a point of time at which the illuminating light passed through the shutter 3 actually begins to be applied to the reticle R, and has a substantially constant delay with respect to the time $t_{SO}$ when the signal $CS_1$ which is an exposure starting command is produced. Likewise, the time $t_5$ when the applications of the exposure light to the reticle R is completely discontinued has a substantially constant delay with respect to the time $t_{SC}$ when the signal Sc is produced.

As is apparent from Figure 6A, the total exposure amount (proper exposure amount) Eu provided to the wafer W is expressed as follows with k as a constant:

$$Eu = k \int_{t_0}^{t_5} P(t) \cdot dt \qquad\qquad \cdots\cdots (1)$$

It is because the operational speeds of the shutter 3, the motor 4, the driver 22, etc. are finite that the characteristic P(t) of Figure 6A does not become rectangular with respect to time. However, the reproducibility of the characteristic P(t) is sufficiently good, and during multitime exposure (during the opening and closing of the shutter), the relation of the characteristic P(t) is reproduced substantially completely.

The microprocessor $\mu$P 150 shown in Figure 5 calculates delay times $(t_0 - t_{SO})$ and $(t_5 - t_{SC})$ in the characteristic P(t) and the acceleration of the variation in illumination from the shutter opening operation starting time $t_0$ till the shutter closing completion time $t_5$, on the basis of the data stored in the RAM 111, and stores them in the memory in the microprocessor $\mu$P 150.

Now, Figure 6B shows an example of the characteristic V(t) when during the exposure operation, the Z stage 14 is moved at a special speed pattern in the direction of the optic axis on the basis of the speed data stored in the Z stage characteristic data portion 130. Here, the Z stage 14 begins to be moved at a low speed $v_1$ at a time $t_S$ before the time $t_0$ when the shutter opening command is generated, and keeps the speed $v_1$ from the time to till a time $t_1$ which is a predetermined time after the time $t_0$, and accelerates to a speed $v_2$ approximate to the highest speed from after the time $t_1$. Then, the Z stage decelerates again to a low speed $v_3$ (substantially equal to $v_1$) from after a time t3 after the Z stage is stabilized at the speed $v_2$, and is maintained at the speed $v_3$ until the closing of the shutter is completed.

Figure 6C shows the position characteristic Z(t) of the Z stage 14 in the direction of the optic axis when the Z stage 14 is moved at the characteristic V(t) of Figure 6B. In Figure 6C, a position ZC is a position at which the pattern projection image of the reticle R coincides with the surface of the wafer as the best image.

In the present embodiment, the speed of the Z stage 14 is brought into the highest state near the position at which the best image plane coincides with the surface of the wafer, and is kept at the lowest possible speed during the opening and closing operations of the shutter 3. That is, during one shutter opening operation, the Z stage 14 is moved while being accelerated and decelerated at a predetermined characteristic.

Therefore, it is necessary that driving conditions such as the acceleration condition and the deceleration condition of the Z stage 14 be determined before exposure is started.

Now, of course, the step of introducing the illumination characteristic P(t) into the RAM 111 and calculating various data may be suitably executed plural times and the result may be averaged. Also, in the previous example, the opening-closing of the shutter 3 is controlled so that a proper exposure amount may be obtained from first by the integrator circuit 21, but in the case of a mode in which the opening-closing of the shutter 3 is controlled by time, the set shutter time can be adjusted until a proper exposure amount is obtained, and after the proper exposure amount is obtained, the characteristic P(t) of Figure 6A can be stored in the RAM 111. In order to confirm whether proper exposure is obtained on the wafer surface side (the image side of the projection lens PL), use may also be made of a photoelectric sensor 19 provided on the XY stage 13. Further, the characteristic P(t) to be stored in the RAM 111 may be made from the photoelectric signal of the photoelectric sensor 19 obtained through a processing system 24.

Description will now be made of a method of determining the movement conditions of the Z stage 14 in the present embodiment. Supposing the actual exposure operation, the wafer W is at a position Zs before the exposure is started, and the wafer W starts movement in the Z direction (the direction of the optic axis) from here. Now, as shown in Figures 6A - 6C, the Z stage 14 at the position Zs starts to be driven at a time $t_S$, and is uniformly moved at a low speed $v_1$. The shutter opening command (signal $CS_1$) is output at a time $t_{SO}$ so that the shutter 3 may begin to be opened after the speed of the Z stage 14 is stabilized at $v_1$. Thereupon, at a time $t_0$, exposure to the wafer W is started and at that time, the Z stage 14 has arrived at a position $Z_0$. The uniform movement at the speed $v_1$ is continued until a time $t_1$, i.e., until the position of the wafer W in the Z direction comes to an acceleration position $Z_1$, whereafter the Z stage 14 is again accelerated at an acceleration $\underline{a}$ and at a time $t_2$, it reaches a speed $v_2$ (the substantially highest speed). Accordingly, the acceleration $\underline{a}$ is expressed as follows:

$$a = (v_2 - v_1)/(t_2 - t_1) \qquad\qquad (2)$$

Also, the positions of the Z stage 14 at the times $t_1$ and $t_2$ are $Z_1$ and $Z_2$. From the time $t_2$ till a time $t_3$, the Z stage is uniformly moved at the speed $v_2$ and on its way, the Z stage passes through the best focus position ZC for the wafer W. When at the time $t_3$, the Z stage comes to a position $Z_3$, the Z stage is decelerated at an acceleration $\beta$, and at a

time $t_4$ (a position $Z_4$), it is dropped to a low speed $v_3$. At this time, the acceleration $\beta$ ($\beta < 0$) is expressed as follows:

$$\beta = (v_3 - v_2)/(t_4 - t_3) \tag{3}$$

From the time $t_4$ till a time $t_5$ (from the position $Z_4$ to a position $Z_5$), the wafer W is uniformly moved at the speed $v_3$, and at a time $t_{SC}$, the shutter closing command (signal Sc) is output.

In the present embodiment, exposure amounts $E_1$ and $E_4$ provided to the wafer W at the positions $Z_0$, $Z_1$, $Z_4$ and $Z_5$ and between the positions $Z_0$ - $Z_1$ and between the positions $Z_4$ - $Z_5$ greatly contribute to the enlargement of the depth of focus.

The estimation of these exposure amounts $E_1$ and $E_4$ is pre-calculated by the microprocessor $\mu$P 150 in Figure 5, and in this calculation, conditions may be automatically determined by the use of the amount of depth of focus ($\pm$ DOF) of the projection lens PL itself and the proper exposure amount (total exposure amount) Eu input from the data input portion 120, but an operation processed under conditions uniquely set by the operator is also regarded as possible.

Now, the conditions are automatically determined as an example as follows by the microprocessor $\mu$P 150:

$$Z_0 = + \text{DOF}, \ Z_1 = + 0.8 \times \text{DOF}$$

$$Z_5 = - \text{DOF}, \ Z_4 = - 0.8 \times \text{DOF}$$

$$E_1 = 0.35 \times \text{Eu}, \ E_4 = 0.35 \times \text{Eu}$$

As is clear from this, the exposure amount provided to the wafer W while the Z stage 14 is moved from the position $Z_1$ to the position $Z_4$ is about 30% of the total exposure amount Eu.

The numerical values (parameters) shown above by way of example are standard values to the last, and can be suitably changed by the operator. However, if the parameters are changed at random, it does not always follow from various limitations (such as the speed and movement stroke of the Z stage and the illumination) that the conditions are properly set. In that case, as will be described later in detail, a warning is generated through the bus line $DB_3$ to inform the operation that the proper setting of the conditions is impossible by the parameters changed by the operator.

Now, when the exposure amount $E_1$ is determined in accordance with the above-described parameters, the time $t_1$ when the exposure amount integrated from the exposure starting time $t_0$ (the integrated value) becomes $E_1$ can be found from the relation of the following equation (in which $k_1$ is a constant), on the basis of the illumination variation characteristic P(t) stored in the RAM 111:

$$E_1 = \int_{t_0}^{t_1} k_1 \cdot P(t)\,dt \qquad \dots\dots (4)$$

When the time $t_1$ is thus found, the speed $v_1$ at which the Z stage is to be moved from the position $Z_0$ to the position $Z_1$ at the time ($t_1$ - $t_0$) can be found from the following equation:

$$v_1 = (Z_1 - Z_0)/(t_1 - t_0) \tag{5}$$

Here, the spacing between the positions $Z_0$ and $Z_1$ may preferably be as small as possible relative to the depth of focus DOF (ZC - $Z_0$, $Z_5$ - ZC) of the projection lens PL, and as an example, may desirably be 1/3 or less of the value DOF.

When the exposure amount $E_4$ is determined in a similar manner, the time $t_4$ when the exposure amount (integrated value) provided to the wafer W from the time $t_4$ till the time $t_5$ becomes $E_4$ is inversely calculated from the relation of the following equation (in which $k_2$ is a constant) on the basis of the illumination variation characteristic P(t):

$$E_4 = \int_{t_4}^{t_5} k_2 \cdot P(t) \, dt \qquad \cdots \cdots (6)$$

Here, the time $t_5$ is known, and is already prescribed on the characteristic $P(t)$ stored in the RAM 111.

When the time $t_4$ is thus found, the speed $v_3$ at which the Z stage is to be moved from the position $Z_4$ to the position $Z_5$ at the time $(t_5 - t_4)$ can be found from the following equation:

$$v_3 = (Z_5 - Z_4)/(t_5 - t_4) \qquad (7)$$

Here, the spacing between the positions $Z_4$ and $Z_5$ may also desirably be 1/3 or less of the depth of focus DOF of the projection lens PL. By the above-described calculations, the times $t_0 - t_1$, the times $t_4 - t_5$ and the speeds $v_1$ and $v_3$ are determined.

From what has been described above, it will be seen that when the total exposure time $(t_5 - t_0)$ is Tt, the movement of the Z stage 14 from the position $Z_1$ to the position $Z_4$ (the acceleration and deceleration range from the time $t_1$ till the time $t_4$) should be effected during

$$Tt - (t_1 - t_0) - (t_5 - t_4) = T\alpha\beta. \qquad (8)$$

At this time, from the acceleration and deceleration characteristics of the Z stage 14, the time $(t_2 - t_1)$ and the time $(t_4 - t_3)$ are substantially constant values and thus, when the total of the time $(t_2 - t_1)$ and the time $(t_4 - t_3)$ becomes greater than the time $T\alpha\beta$, the control of the Z stage becomes unstable and the expected depth enlarging effect cannot be attained.

When it is confirmed that $(t_2 - t_1) + (t_4 - t_3) \leqq T\alpha\beta$, the microprocessor µP 150 finds the relation among the acceleration discontinuing time $t_2$ and the deceleration starting time $t_3$ of the Z stage 14 and the speed $v_2$. Here, the distance from the position $Z_1$ to the position $Z_4$ is represented by the following equation:

$$Z_4 - Z_1 = 1/2 \cdot a(t_2 - t_1)^2 + v_1(t_2 - t_1)$$

$$+ v_2(t_3 - t_2) + v_3(t_4 - t_3)$$

$$- 1/2 \cdot \beta(t_4 - t_3)^2 \qquad (9)$$

Further, the accelerations a and $\beta$ are known from equations (2) and (3) and therefore, this equation (9) can be rewritten as follows:

$$Z_4 - Z_1 = 1/2 \cdot v_1(t_2 - t_1)$$

$$+ 1/2 \cdot v_2(t_4 + t_3 - t_2 - t_1)$$

$$+ 1/2 \cdot v_3(t_4 - t_3) \qquad (10)$$

In this equation (10), the times $t_1$ and $t_4$ and the speeds $v_1$ and $v_3$ have all been previously determined and therefore, equation (10) becomes a relational expression having $v_2$, $t_2$ and $t_3$ as parameters.

Accordingly, if the speed $v_2$ and the time $t_2$ are suitably determined, the time $t_3$ will be correspondingly determined and the positions and the driving conditions of the Z stage at the respective times during exposure $(t_0 - t_5)$ will be accurately determined.

In the case of the present embodiment, the best focus position ZC lies substantially at the midpoint between the positions $Z_1$ and $Z_4$ and therefore, as shown in Figure 6C, the position characteristic $Z(t)$ becomes a curve substantially point-symmetrical about the position ZC.

Also, in determining the driving conditions of the Z stage 14, the accelerations a and $\beta$ of the Z stage may be fixed at predetermined values in advance on the basis of equations (9), (2) and (3) and the times $t_2$ and $t_4$ may be determined in conformity with the value of the speed $v_2$ from equations (2) and (3), whereby the driving conditions can likewise be found accurately.

Since in the manner described above, the movement conditions including the movement speed of the wafer W in the Z direction during exposure and the Z position are determined, exposure may thereafter be effected in accordance with the determined conditions, whereby between the positions $Z_0$ to $Z_1$, the exposure amount $E_1$ is accurately provided to the wafer W, and between the positions $Z_4$ to $Z_5$, the exposure amount $E_4$ is accurately provided to the wafer W. At the same time, the total exposure amount Eu is also controlled accurately. Also, if the acceleration a between the times $t_1$ to $t_2$ and the acceleration $\beta$ between the times $t_3$ to $t_4$ are controlled to $a = -\beta$, the existence probability of the wafer at the positions $Z_1$ to $Z_4$ with respect to the Z direction will become ZC $\simeq (Z_1 + Z_4)/2$ substantially symmetrically about the best focus position ZC, and this will greatly contribute to the effect of enlarging the depth of focus.

The initial position of the Z stage 14 has been shown as $Z_5$ but alternatively, the initial position may be a position above $Z_5$ and with the progress of exposure, the Z stage may be moved reversely to $Z_4$, $Z_3$ ..., $Z_0$.

Also, the Z position of the Z stage during exposure can be detected by the AF unit 18 shown in Figure 4, but if the movement width (2 · DOF) of the Z stage during exposure is great, the Z position may exceed the detection range of the AF sensor. In such case, the focus signal cannot be obtained near the positions $Z_1$ and $Z_4$ and therefore, design can be made such that the positional information is obtained from a potentiometer or a position sensor which monitors the amount of driving of the Z stage. In connection with this, for example, the time when at the best focus position ZC, the focus signal assumes a state representative of in-focus (for example, the zero point) is checked up while the level of the surface of the wafer W is being monitored by an AF sensor, and whether this time is substantially at the midpoint between the times $t_2$ and $t_3$ is judged, whereby whether the exposure operation for one shot has been effected well can be roughly known.

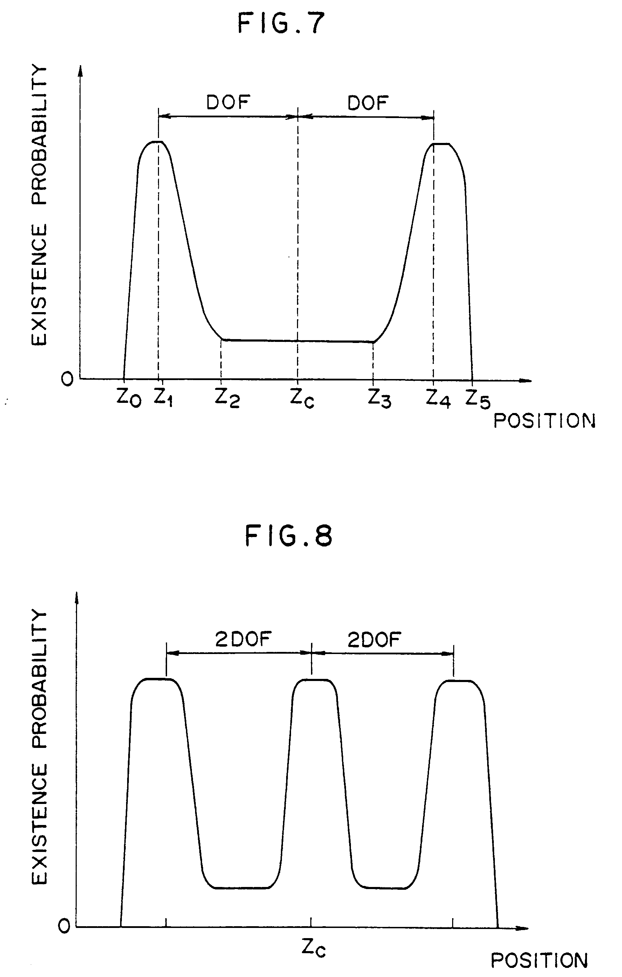

Now, Figure 7 graphically shows the existence probability of the wafer (or concentricity of the exposure amount) with respect to the Z direction when exposure is effected at the characteristics shown in Figures 6A, 6B and 6C. From the fact that the peaks of the existence probability exist near the positions $Z_0 - Z_1$ and near the positions $Z_4 - Z_5$, the enlargement of the depth of focus can be achieved. In the present embodiment, the exposure amount cannot be made zero at the positions between the peaks, e.g. $Z_2 - Z_3$. This is because the Z stage is continuously moved. To most enhance the effect of enlarging the depth of focus, it is necessary that the existence probability shown in Figure 7 is provided and the exposure amount ($E_1$) at the positions $Z_0 - Z_2$ and the exposure amount ($E_4$) at the positions $Z_3 - Z_5$ be made substantially equal to each other, but in the present embodiment, the speed characteristic V(t) and the position characteristic Z(t) of the Z stage and the illumination characteristic P(t) during the opening-closing of the shutter are strictly controlled and therefore, the control accuracy of the exposure amount is maintained good.

Figure 8 shows the existence probability of the wafer when the number of times of multiplex exposure is three, and represents a case where as the driving pattern of the Z stage 14 when the shutter is open, the low speed uniform movement → acceleration and deceleration → the low speed uniform movement are repeated twice. Peaks exist at three locations with respect to the position in the Z direction, and the central peak is adjusted to the best focus position ZC, and the peaks on the opposite sides of the central peak are spaced apart from each other by an amount corresponding to the depth-of-focus width 2·DOF of the projection lens PL. Again in this case, it is more desirable that the exposure amounts corresponding to the three peaks be uniform.

As described above, in the present embodiment, the characteristic P(t) of Figure 6A is proportionally enlarged in the direction of the time axis with the deterioration of the lamp intensity and therefore, after one lot of wafers (25 wafers) have been treated, the characteristic P(t) should preferably be re-measured. Also, after the characteristic P(t) has been stored in the RAM 111, it is better to adopt a timer mode in which the operation of the shutter 3 is controlled by time, and control the time $t_{so} - t_{sc}$ so as to be set as the shutter time.

A second embodiment of the present invention will now be described.

In the second embodiment, when it is known on the basis of a warning signal obtained through the bus line $DB_3$ of the microprocessor $\mu$P 150 that multiplex exposure becomes incomplete in the calculation process, there is given the function of relieving it. Description will first be made of a state in which the warning signal may be produced.

In most cases, the warning is produced when the time from the opening start time $t_0$ of the shutter 3 till the closing completion time $t_5$ of the shutter 3 becomes considerably short as compared with the movement speed variation pattern of the Z stage 14. For example, when frcm the limit of the driving characteristic of the Z stage 14, the time $t_1 - t_4$ becomes so short that the constant high speed range (speed $v_2$) as shown in 6B does not exist, the range in which a minimum existence probability is provided between the positions $Z_2 - Z_3$ as shown in Figure 7 becomes null and the effect of enlarging the depth of focus cannot sufficiently obtained.

Accordingly, at a point of time whereat it is found in the calculation process that good control is impossible, the actual exposure time ($t_0 - t_5$) for the wafer W can be lengthened until good control becomes possible.

In the present embodiment, the exposure time per one shot becomes slightly longer and some reduction in throughput is caused, but the reduction in throughput heretofore experienced can be avoided. For that purpose, an ND filter for stepwisely changing the intensity of the illuminating light is removably provided in the illuminating optical system of the projection exposure apparatus. As regards the transmittance of the ND filter, light may be decreased, for example, at every 10% and finally to the order of 50%.

As another means, it would occur to mind to reduce the supplied electric power to the lamp 1 through the lamp control unit 23 shown in Figure 4. In such case, the supplied electric power must be reduced within such a range that the lamp 1 continues to be stably turned on.

In any case, in a state in which after the intensity of the illuminating light is reduced by a predetermined amount, the opening-closing of the shutter 3 is again effected so that a proper exposure amount may be obtained, the illumination characteristic P(t) can be again stored in the RAM 111 and similar calculation can be executed.

While each embodiment has been described with respect to an example in which the wafer W is moved in the direction of the optic axis, a similar effect will be obtained by a construction in which a chose air chamber in the projection lens PL is hermetically sealed and the pressure in the air chamber is forcibly adjusted, whereby the focus position of the projection lens PL itself (the surface conjugate with the reticle) is moved in the direction of the optic axis. Also, in the case of a both-side telecentric projection lens, even if a construction is adopted in which one or more lens elements positioned on the reticle side are finely moved by a piezo element or the like, the projected image (the best focus plane) can be parallel-shifted in the direction of the optic axis.

Next, an example of optimum control at the time when projection exposure is effected with respect to a contact hole pattern will be explained as a third embodiment of the invention. In this embodiment exposure amount in the direction of the optic axis is concentrated in the same way as that of the foregoing embodiments.

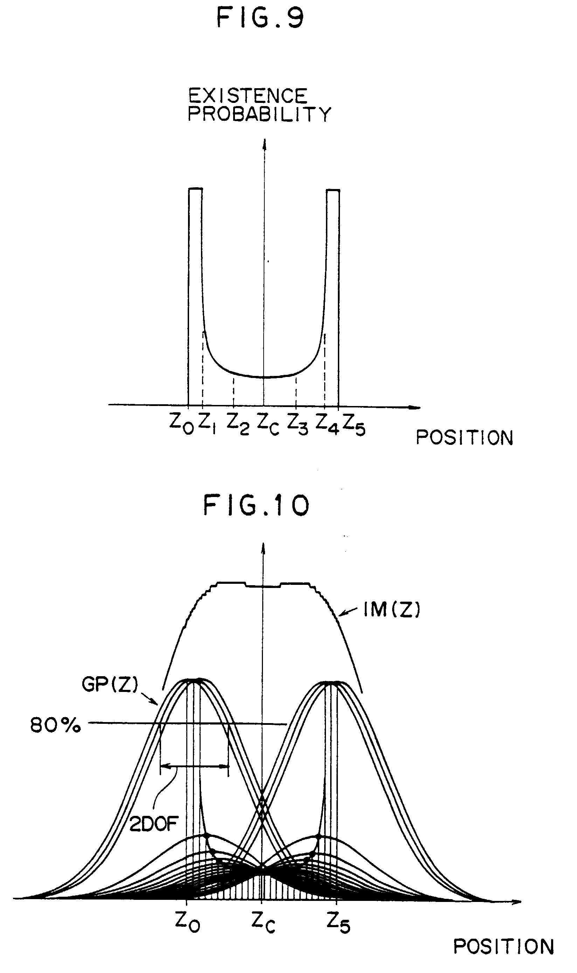

Figure 9 shows the characteristic of the existence probability simulated on the basis of the position characteristic $Z(t)$ of the Z stage and is the same one as shown in Figure 7. In Figure 9, the existence probability from times $t_0$ to $t_5$ is shown, and the existence probability is constant in the low speed uniform movement ranges from times $t_0$ to $t_1$ and from times $t_4$ to $t_5$. For simplifying the explanation below, changes in illumination at the rise and the fall of the illumination characteristic $P(t)$ are neglected, and it is assumed that the illumination is constant over time interval from $t_0$ to $t_5$ (where the shutter is fully opened).

Generally, the existence probability is defined as time $\Delta t$ required for unit displacement $\Delta Z$ in the Z direction, and is treated as $\Delta t / \Delta Z$.

In the case where exposure is effected with respect to the projection image of the contact hole pattern under distribution of such existence probability, the intensity distribution in the optic axis in the center of the projection image or in the neighborhood thereof of one contact hole pattern may be considered to take approximately a Gaussian distribution because the size of the pattern is close to the resolution limit of the projection lens. Figure 10 is the result of simulation on the distribution of the quantity of light by the contact hole image in the direction of the optic axis.

The distribution of the quantity of light in the direction of the optic axis (in the Z direction) may be obtained by convolution of the product of the existence probability characteristic (function) shown Figure 9 and the function of the Gaussian distribution. In the case of simulation by a computer, Gaussian distribution curve GP(Z) is so shifted in the Z direction along the curve of the existence probability that the peak of the curve GP(Z) at each point in the Z direction may be located on the curve of the existence probability, and the Gaussian distribution curves thus obtained are summed to obtain the light quantity distribution IM(Z).

The width in the Z direction at a level where the intensity of one Gaussian distribution GP(Z) is about 80% of the peak value, corresponds to the effective "depth of focus" width 2·DOF of the projection lens. From the simulation shown in Figure 10, the light quantity distribution IM(Z) is substantially flat in the movement range on width from $Z_0$ to $Z_5$ of the Z stage. This means that, when the projection image plane is set toa position ZC and the surface of the wafer is shifted between the positions $Z_0$ and $Z_5$, the quantity of light of the contact hole image applied to the resist layer is substantially constant. In other words, the fact that the quantity of light (the contact hole image) is substantially constant over the long range in the direction of the optic axis, means that the apparent depth of focus is made larger to that extent.

Meanwhile, in the simulation of Figure 10, the ratio (Z-Span/2·DOF) of the movement range Z-span of the Z stage from the position $Z_0$ to the position $Z_5$ to the "depth of focus" width 2·DOF of the single unit of the projection lens is about 2.24. This is because, during exposure operation from the position $Z_0$ to the position $Z_5$, the shutter is fully opened and the illumination is constant, and actually the ratio is slightly smaller.

From the simulation the optimum value of the movement range of the Z stage can be obtained. If the ratio Z-Span/2·DOF is made smaller from the stage shown in Figure 10, the light quantity distribution IM(Z) rapidly changes to form a Gaussian distribution peaked at the position ZC. If the ratio Z-Span/2·DOF is made larger, the light quantity distribution IM(Z) falls at the position ZC and has the peaks between the position $Z_0$ and ZC and between the positions ZC and $Z_5$. According to the experiments, it has been formed that, in the case of the contact hole pattern, if the movement range of the Z stage is so determined that the light quantity distribution is substantially flat, the apparent depth of focus is sufficiently extended and further the deterioration of contrast is made minimum.

In the third embodiment, a software for carrying out the simulation as shown in Figure 10 is provided in the stepper, by which the existence probability chacteristic curve is produced based on various parameters under the exposure condition designated by user and the Gaussian distribution GP(Z) is shifted in the Z direction along the existence probability curve, thereby calculating the quantity distribution IM(Z) of the contact hole pattern, where the peak of each Gaussian distribution is made coincident with the curve of the existence probability when the shutter is in the fully opened state, while during the opening operation or closing operation of the shutter the peak of each Gaussian distribution is adjusted to be on a point lowered from the value of the existence probability to the extent of the lowered amount from the illumination obtained at the time when the shutter is fully opened.

The thus obtained light quantity distribution IM(Z) is displayed by a cathode-ray tube or the like on the control panel of the stepper, and the width in the Z direction of the flat portion which is within the tolerance range is calculated and displayed. This is advantageous because the operator can confirm previously whether the optimum result is expected under the set exposure condition, and that resetting of another exposure condition can be easily made.

In addition to warning or anouncing as described with respect to the second embodiment, anouncing to the operator may be made to notice that there is any problem on exposure condition in view of the characteristic of the light quantity distribution IM(Z) obtained by the simulation.

Meanwhile, the substantially constant light quantity distribution in the Z direction as shown in Figure 10 is particularly advantageous in the case where the wafer surface has continuous unevenness since the pattern is formed accurately with respect to each of uneven or stepped portions on the wafer surface.

In the case where steps or uneven portions are located mainly at the memory cell portion and the peripheral circuit portions as in the case of DRAM pattern, it is not necessary to make the light quantity distribution of the contact hole image constant in the Z direction, but rather it may be so set that the light quantity distribution is larger at two portions, the higher portion (memory call portion) and the lower portion (peripheral circuit) of the stepped portions. For this purpose, the movement range Z-Span of the Z stage may be extendned.

As described above, according to the present invention, during one exposure time (one shutter opening operation), the projection image plane and the photosensitive substrate are moved relative to each other in the direction of the optic axis at a pre-controlled speed characteristic and therefore, the effect of enlarging the depth of focus can be attained without extremely reducing the photosensitive substrate treating ability (throughput) per unit time. Also, the illumination variation characteristic of the illuminating light on the mask is found in advance before the main exposure to the photosensitive substrate and therefore, the desired exposure amounts ($E_1$, $E_4$, etc.) input by the operator can be exactly concentrated on particular points (two or three pointsl within the focus range set by the operator and at the same time, the total exposure amount for cne shot area can also be accurately controlled.

**Claims**

1. A projection exposure method for projecting a pattern image of a mask on a substrate through a projection optical system comprising the steps of:

   providing said substrate movable relatively to an image plane of said projection optical system in a predetermined range along an optic axis of said projection optical system; and
   making an exposure amount on said substrate in both end portions relatively larger than an exposure amount on said substrate in a middle portion when the predetermined range is divided into at least three portions along the optic axis in exposing said pattern image on said substrate.

2. A projection exposure apparatus for projecting a pattern image of a mask on a substrate through a projection optical system comprising:

   a movable stage holding said substrate and capable of moving said substrate and an image plane of said projection optical system relatively in a predetermined range along an optic axis of said projection optical system;
   an exposure amount controller for exposing said pattern image on said substrate so as to make an exposure amount substrate in both end portions relatively larger than an exposure amount on said substrate in a middle portion when the predetermined range is divided into at least three portions along the optic axis.

3. A projection exposure apparatus having an illuminating system for illuminating a mask (R) formed with a predetermined pattern, a shutter (3) for changing over the application of illuminating light to said mask (R) and the interception of the illuminating light, a projection optical system (PL) for projecting the pattern image of said mask, a movable stage (14) holding a photosensitive substrate (W) near the projection image plane of said projection optical system (PL) and capable of moving said photosensitive substrate (W) in the direction of the optic axis while said shutter (3) is open, stage control means (18) for controlling said movable stage with a predetermined operational characteristic, and shutter control means (22) for controlling the opening-closing of said shutter on the basis of the quantity of an exposure amount of said substrate, characterized by the provision of interlocking means (100) for interlocking the operations of said shutter control means (22) and said stage control means (18) so that on the basis of the operational characteristic of said shutter (3) and the operational characteristic of said movable stage (14), the distribution of an existence probability of said substrate (W) obtained under the movement of said substrate (W) with said movable stage from the opening operation starting point of time till the closing operation completing point of time of said shutter (3), with respect to the direction of the optic axis, may assume substantially equal maximum values at least two locations in the direction of the optic axis.

4.  Illumination exposure apparatus for illuminating a substrate, the apparatus comprising a light source having a focal plane; drive means for causing relative movement of the substrate and the focal plane of the light source in a direction perpendicular to the substrate surface; shutter means for selectively obscuring the substrate from the light source; and means for controlling both the shutter means and the drive means such that, in use, the shutter means is operated during said relative movement so as to maximise the illumination in at least two discrete focal planes.

5.  A method of exposing a substrate by focussing an image of a mask thereon, the method comprising causing relative movement between the focal plane and the substrate in a direction normal to the substrate surface during the exposure, and controlling the intensity of exposure so as to cause at least two intensity peaks to occur at different relative positions of the focal plane and substrate.

FIG.1A
PRIOR ART

FIG.1B
PRIOR ART

FIG.1C
PRIOR ART

EP 0 819 988 A1

# F I G. 2

# F I G. 3

# FIG.4

## FIG.5

ILLUMINATION

FIG.6A

SPEED

FIG.6B

POSITION

FIG.6C

## FIG.7

## FIG.8

# FIG.9

EXISTENCE
PROBABILITY

$Z_0$ $Z_1$ $Z_2$ $Z_C$ $Z_3$ $Z_4$ $Z_5$    POSITION

# FIG.10

IM(Z)

GP(Z)

80%

2DOF

$Z_0$ $Z_C$ $Z_5$    POSITION

<table>
<tr><td colspan="2">European Patent Office</td><td>EUROPEAN SEARCH REPORT</td><td>Application Number<br>EP 97 20 2676</td></tr>
</table>

## DOCUMENTS CONSIDERED TO BE RELEVANT

| Category | Citation of document with indication. where appropriate. of relevant passages | Relevant to claim | CLASSIFICATION OF THE APPLICATION (Int.Cl.6) |
|---|---|---|---|
| X | FUKUDA H ET AL: "Improvement of defocus tolerance in a half-micron optical lithography by the focus latitude enhancement exposure method: simulation and experiment" JOURNAL OF VACUUM SCIENCE & TECHNOLOGY B (MICROELECTRONICS PROCESSING AND PHENOMENA), JULY-AUG. 1989, USA, vol. 7, no. 4, ISSN 0734-211X, pages 667-674, XP002044734 * page 668, right-hand column, line 35 - line 43 * * page 669, left-hand column, paragraph 4 - paragraph 5; figure 3 * * page 670, left-hand column, paragraph 2; figure 6 * * page 671, left-hand column, paragraph 4 - right-hand column, paragraph 3; figure 8 * | 1,2 | G03F7/20 |
| A | FUKUDA H ET AL: "A new method for enhancing focus latitude in optical lithography: FLEX" IEEE ELECTRON DEVICE LETTERS, APRIL 1987, USA, vol. EDL-8, no. 4, ISSN 0741-3106, pages 179-180, XP002044733 * the whole document * | 1,2 | **TECHNICAL FIELDS SEARCHED** (Int.Cl.6)<br><br>G03F |
| E | EP 0 489 426 A (SONY CORP) * the whole document * | 1,2,4,5 | |
| X | PATENT ABSTRACTS OF JAPAN vol. 007, no. 090 (P-191), 14 April 1983 -& JP 58 017446 A (HITACHI SEISAKUSHO KK), 1 February 1983, * abstract; figures * | 1,2,4,5 | |
| A | | 3 | |

-/--

The present search report has been drawn up for all claims

| Place of search | Date of completion of the search | Examiner |
|---|---|---|
| THE HAGUE | 28 October 1997 | Heryet, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

EP 0 819 988 A1

<table>
<tr><td></td><td><strong>European Patent Office</strong></td><td><strong>EUROPEAN SEARCH REPORT</strong></td><td>Application Number<br>EP 97 20 2676</td></tr>
</table>

## DOCUMENTS CONSIDERED TO BE RELEVANT

| Category | Citation of document with indication. where appropriate. of relevant passages | Relevant to claim | CLASSIFICATION OF THE APPLICATION (Int.Cl.6) |
|---|---|---|---|
| A | "EXTENDED FOCAL DEPTH OPTICAL MICROLITHOGRAPHY"<br>IBM TECHNICAL DISCLOSURE BULLETIN,<br>vol. 32, no. 1, June 1989,<br>pages 125-127, XP000033309<br>* the whole document * | 1-5 | |
| D,A | US 4 869 999 A (FUKUDA HIROSHI ET AL)<br>* column 4, line 6 - line 60 *<br>* column 9, line 16 - column 10 *<br>* figures * | 1-5 | |

TECHNICAL FIELDS SEARCHED (Int.Cl.6)

The present search report has been drawn up for all claims

| Place of search | Date of completion of the search | Examiner |
|---|---|---|
| THE HAGUE | 28 October 1997 | Heryet, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document. but published on, or after the filing date
D : document cited in the application
L : document cited for other reasons
& : member of the same patent family. corresponding document

EPO FORM 1503 03.82 (P04C01)

22